# EUROPEAN PATENT APPLICATION

(11) **EP 2 093 792 A1**
(43) Date of publication of application: **26.08.2009**
(21) Application number: 08105700.2
(22) Date of filing: 30.10.2008
(51) Int. Cl.: H01L 21/48, H01L 25/065

(54) **Method for power semiconductor module fabricaton, its apparatus, power semiconductor module and its junction method**

(30) Priority: 01.11.2007 JP 2007285519
(71) Applicant: Hitachi Ltd., Chiyoda-ku Tokyo (JP)
(72) Inventor: Funakoshi, Sunao, Tokyo 100-8220 (JP); Ishikawa, Katsumi, Tokyo 100-8220 (JP); Soga, Tasao, Tokyo 100-8220 (JP)
(74) Representative: Borchert, Uwe Rudolf

(57) **Abstract**

A power semiconductor module includes first and second insulating substrates, a power semiconductor device joined directly or through another element to opposite sides of the first and second insulating substrates and first and second heat spreaders joined with joining material having fluidity upon joining so as to put the first and second insulating substrates between the first and second heat spreaders. When the power semiconductor module is fabricated, the first and second insulating substrates are joined to the first and second heat spreaders, respectively, in the state that weight bearing on joining material is reduced by means of resilient member.

## Description

### BACKGROUND OF THE INVENTION

The present invention relates to a fabrication method of a power semiconductor module, a fabrication apparatus of a power semiconductor module, a power semiconductor module and a joining method.

In recent years, a demand for increased output of an inverter used in a hybrid automobile is being increased and high output power of a power module constituting the inverter is required. On the other hand, there is restriction on space for installing components in an automobile and accordingly the power module is also required to be made more compact at the same time. Thus, in order to cope with the high output power and the compactness of the automobile, it is necessary to enhance cooling performance of the power module.

Heretofore, JP-A-2005-175130 discloses, as technique for enhancing cooling performance of the power module, that electrodes, insulating sheets, heat spreaders and heat sinks are disposed over and under power semiconductor device to cool the power semiconductor device from above and bottom thereof.

In the structure of the power module in the above prior art, the heat sinks are disposed over and under power semiconductor device, so that the cooling performance can be improved. However, in this structure, any two combined components out of electrodes, insulating resins, heat spreaders and heat sinks are not joined with solder particularly and are pressed against each other using sealing resin to be fixed. Accordingly, there is a problem that contact thermal resistance is increased.

On the other hand, in order to reduce the contact thermal resistance, a method of soldering insulating substrates having both sides to which metal sheets are directly joined to both sides of a chip and further soldering upper and lower insulating substrates to heat spreaders can be also adopted, although in this method the whole weight of the heat sink part directly bears on the solder upon soldering of the insulating substrates and the heat spreaders. Accordingly, the solder is forced out from the periphery of the insulating substrates and comes into the insulating substrates to cause shirt-circuiting sometimes, so that the reliability of the module comes into question.

### SUMMARY OF THE INVENTION

The present invention has been made in view of the above problem and it is an object of the present invention to provide a fabrication method of a power semiconductor module, a fabrication apparatus of a power semiconductor module, a power semiconductor module and a joining method in which contact thermal resistance is reduced and reliability is improved.

In order to achieve the above object, according to the present invention, the fabrication method of the power semiconductor module including first and second insulating substrates, a power semiconductor device joined directly or through another element to opposite sides of the first and second insulating substrates and first and second heat spreaders joined with first joining material so as to put the first and second insulating substrates therebetween comprises joining process of joining the first and second insulating substrates to the first and second heat spreaders, respectively, in the state that weight bearing on the first joining material is reduced by resilient member.

According to the fabrication method of the power semiconductor module according to the present invention, weight bearing on the joining material, of weight of the heat spreader (heat sink) can be reduced when the insulating substrates and the heat spreaders are joined with the joining material such as solder and accordingly the joining material can be prevented from being forced out of the insulating substrates.

Other objects, features and advantages of the invention will become apparent from the following description of the embodiments of the invention taken in conjunction with the accompanying drawings.

### BRIEF DESCRIPTION OF THE DRAWINGS

Fig. 1 is a sectional view illustrating a power semiconductor module according to an embodiment (first embodiment) of the present invention;
Fig. 2 illustrates on an enlarged scale a sealing part of the power semiconductor module according to the embodiment (first embodiment) of the present invention;
Fig. 3 is a sectional view illustrating the power semiconductor module and assembly jigs according to the embodiment (first embodiment) of the present invention;
Fig. 4 is a sectional view illustrating the power semiconductor module according to the embodiment (first embodiment) of the present invention in which springs are removed;
Fig. 5 is a sectional view illustrating part of the power semiconductor module according to the embodiment (first embodiment) of the present invention;
Fig. 6 is a sectional view illustrating part of the power semiconductor module and assembly jigs according to the embodiment (first embodiment) of the present invention;
Fig. 7 is a sectional view illustrating a power semiconductor module and assembly jigs according to another embodiment (second embodiment) of the present invention;
Fig. 8 is a sectional view illustrating part of a power semiconductor module and assembly jigs according to another embodiment (third embodiment) of the present invention;
Fig. 9 is a sectional view illustrating a power semiconductor module according to another embodiment (fourth embodiment) of the present invention;
Fig. 10 is a sectional view illustrating a power semiconductor module according to another embodiment (fifth embodiment) of the present invention; and
Fig. 11 is a sectional view illustrating part of the power semiconductor module according to the other embodiment (fifth embodiment) of the present invention.

### DESCRIPTION OF THE EMBODIMENTS

Preferred embodiments of the present invention are now described with reference to the accompanying drawings.

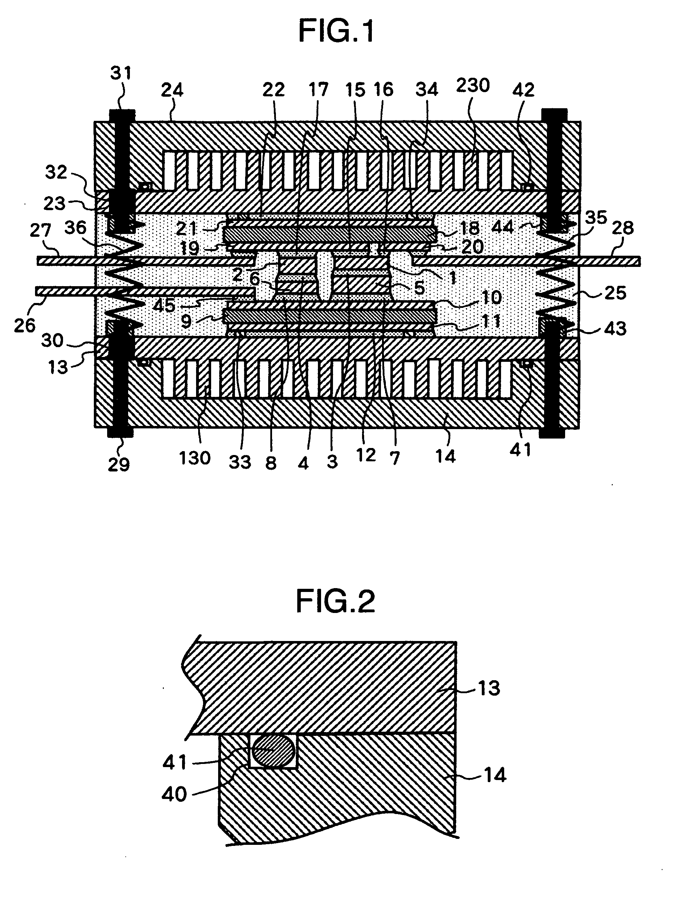

Fig. 1 is a sectional view illustrating a power semiconductor module according to an embodiment (first embodiment) of the present invention. Referring now to Fig. 1, elements constituting the power semiconductor module according to the embodiment are described.

Numerals 1 and 2 shown in Fig. 1 represent power semiconductor devices such as insulated gate bipolar transistors (IGBT) and free-wheel diodes.

Spacers 5 and 6 are connected or joined to the lower sides of the power semiconductor modules 1, 2 with joining materials 3 and 4 such as solder. The spacers 5, 6 have not only the function of adjusting height when the power semiconductor devices 1 and 2 are different in thickness thereof but also the function of preventing discharge from occurring between the electrodes 26 and 27 disposed over and under the devices since the distance therebetween is too short. The spacers 5, 6 are desired to have small electrical resistance and thermal resistance and may be made of not only copper but also compound material of copper and carbon or metal of copper and invar joined to each other.

A lower insulating substrate 9 may be made of aluminum nitride (AlN), alumina (Al₂O₃), silicon nitride (Si₃N₄) and boron nitride (BN), for example, and has both sides on which copper sheets (or aluminum sheets) 10 and 11 are directly joined or brazed. The lower sides of the spacers 5, 6 are joined to the copper sheet 10 on the upper side of the lower insulating substrate 9 with joining materials 7 and 8 such as solder. In case of IGBT device, for example, the copper sheet 10 and a collector electrode (not shown) of the power semiconductor device 1 are electrically connected to each other through the joining material 7 such as solder and a lead 26 is taken out from the copper sheet 10. The lead 26 is made of copper and is soldered to the copper sheet 10 with solder 45. The copper sheet 10 and the lead 26 may be joined to each other by means of ultrasonic joining instead of soldering. Part of the copper sheet 10 may be integrated with the electrode 26 to form a copper sheet integrated electrode structure in which the lead 26 is taken out of the insulating substrate.

The copper sheet 11 disposed on the lower side of the lower insulating substrate 9 and a lower heat spreader 13 are joined to each other with joining material 12 such as solder. The lower heat spreader 13 may be made of copper, tungsten, compound material of copper and carbon, AlSiC or the like. Further, fins 130 are disposed under the heat spreader 13. The fins 130 are attached to the heat spreader 13 by means of welding or brazing or are formed integrally with the heat spreader 13. A case 14 is disposed under the heat spreader 13 and a refrigerant such as antifreezing solution flows between the fins 130 positioned within the case 14. Fig. 2 shows part indicated by A of Fig. 1 on an enlarged scale.

As shown in Fig. 2, groove 40 for O-ring is formed in the case 14 and O-ring 41 seals between the heat spreader 13 and the case 14. The heat spreader 13 and the case 14 are connected by means of bolts 29 and female threads 30 formed in the heat spreader 13 by heli-sert working or the like.

An upper insulating substrate 18 is made of the same material as that of the lower insulating substrate 9 and copper sheets or alumina sheets 19 and 20 are joined on the lower side of the insulating substrate 18 and copper sheet or alumina sheet 21 is joined on the upper side of the insulating substrate 18 directly or by brazing. The upper sides of the power semiconductor devices 1, 2 are joined to the copper sheets 19, 20 with joining materials 15, 16 and 17 such as solder. For example, in case of IGBT device, the copper sheet 19 and an emitter electrode (not shown) of the device 1 are electrically connected to each other through joining material 15 such as solder and lead 27 is taken out from the copper sheet 19. Further, the copper sheet 20 and a gate electrode (not shown) of the device 1 are electrically connected to each other through joining material 16 such as solder and lead 28 is taken out from the copper sheet 20.

The copper sheet 21 joined to the upper side of the upper insulating substrate 18 is connected to an upper heat spreader 23 with joining material 22 such as solder. The upper heat spreader 23 is made of copper. The upper heat spreader 23 is provided with fins 230. A case 24 is disposed over the heat spreader 23 and a refrigerant such as antifreezing solution flows between the fins positioned within the case 24. The heat spreader 23 and the case 24 are connected by means of bolts 31 and female threads 32 formed in the heat spreader 23 by heli-sert working or the like and are sealed by O-ring 42.

The joining material free of lead may be all used in consideration of the environment. As joining material used for joining of core parts of the power semiconductor module such as the power semiconductor devices 1, 2, joining material having the melting temperature higher than that of joining material used for joining of heat spreader may be used. In other words, high-temperature joining material formed by mixing copper particles and thin particles, for example, may be used for joining materials 3, 4 for joining power semiconductor devices 1, 2 and spacers 5, 6, joining materials 7, 8 for joining spacers 5, 6 and copper sheet 10 and joining materials 15, 16, 17 for joining power semiconductor devices 1, 2 and copper sheets 19, 20 and joining material having the melting point lower than that of the joining materials 3, 4, 7, 8, 15, 16, 17 such as, for example, lead-free solder Sn-3Ag-0.5Cu may be used for joining material 12 for joining lower insulating substrate 9 and lower heat spreader 13 and joining material 22 for joining upper insulating substrate 18 and upper heat spreader 23.

Joining materials 12 and 22 are heated to be melted simultaneously or separately to be used for joining. At this time, it is desired to also melt tin contained in high-temperature joining material and use a furnace in an atmosphere in which a vacuum furnace is combined in order to prevent void from being contained in joining material. In the joining process of the heat spreaders 13, 23, when the whole weight of members containing upper heat spreader 23, fins and case bears on joining materials 12, 22, it is apprehended that joining materials 12, 22 are forced out of insulating substrates 9, 18 and come into between upper and lower insulating substrates to cause short-circuiting. In order to avoid such problems, in the embodiment, resilient members such as springs 35, 36 are inserted or disposed between upper and lower heat spreaders 13, 23 and then the joining process is performed, so that the whole weight containing upper heat spreader 23 and the like does not bear on the joining materials to thereby prevent joining materials from being forced out. In this connection, the springs 35, 36 may have natural length, for example, longer than the distance between upper and lower heat spreaders 13, 23 to thereby reduce the weight of upper members bearing on joining materials.

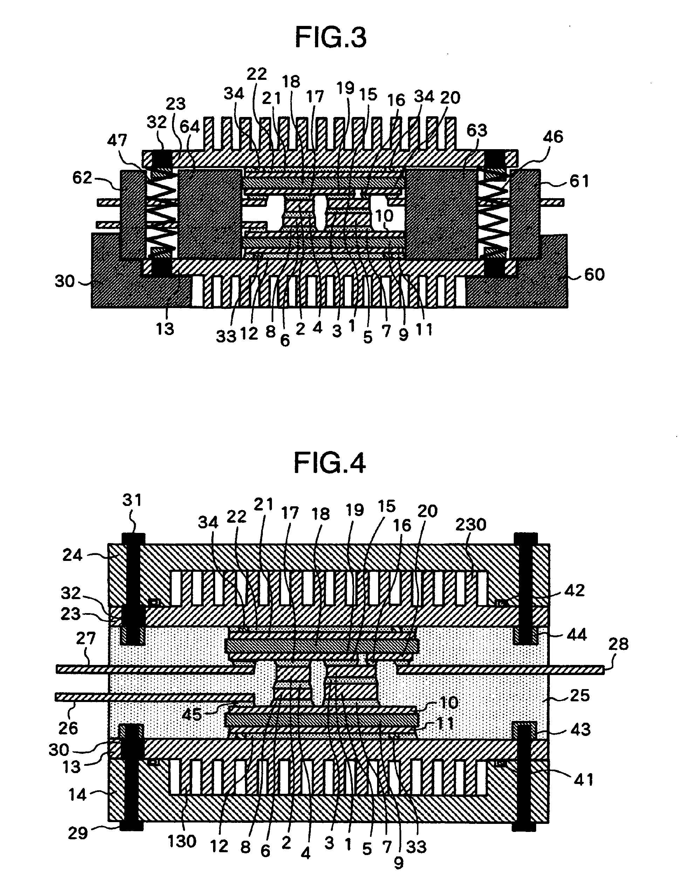

Both ends of spring 35 are fixed by spring supporting members 43, 44. Moreover, in joining process, as shown in Fig. 3, assembly jigs 60 to 64 may be used to fix the spring by the jigs 61 to 64. In addition, after heat spreaders 13, 23 having fins are attached, springs may be left as they are or may be removed. The power semiconductor module shown in Fig. 1 is of final form when the springs are left and the power semiconductor module shown in Fig. 4 is of final form when the springs are removed.

The springs 35, 36 may be metallic coil springs or plate springs. Alternatively, resin material having resilience may be used instead of metal. However, it is necessary that the material can withstand high temperature in the joining process even if it is any material. Furthermore, in order to ensure the minimum thickness of the joining materials 12, 22, protrusions 33 and 34 may be provided on the heat spreaders 13, 23.

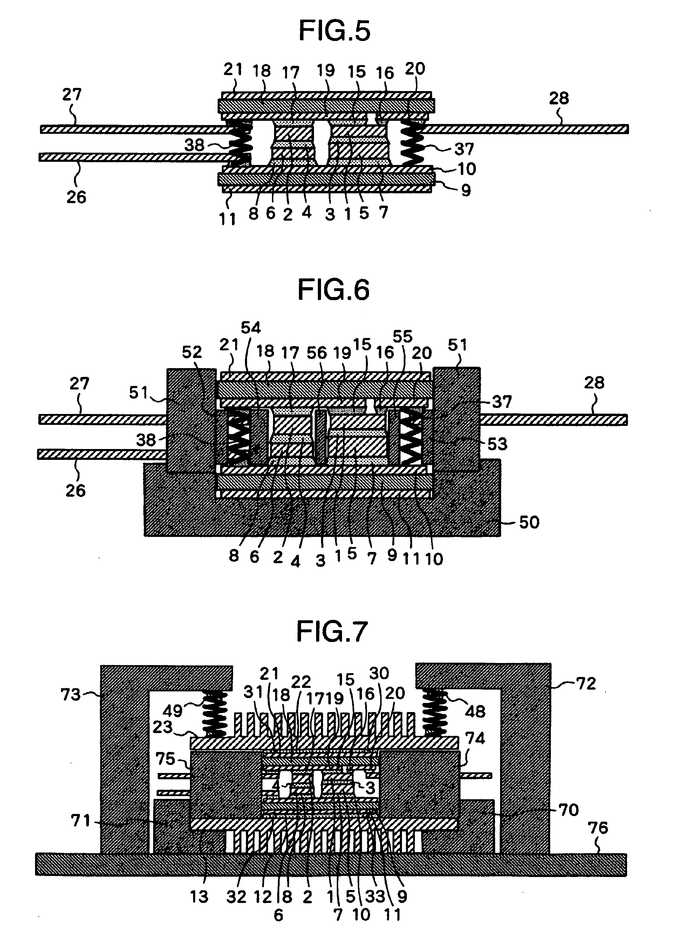

Moreover, in the power semiconductor module shown in Fig. 1, the springs 35, 36 are inserted between heat spreaders 13, 23 to reduce the weight bearing on joining materials when heat spreaders 13, 23 are joined, although the present invention is not limited thereto and even in the joining process of core parts of the power semiconductor module, that is, in the joining process between power semiconductor devices 1, 2 and spacers 5, 6, between spacers 5, 6 and lower insulating substrate 9 and between devices and upper insulating substrate 18, joining materials for joining elements may be prevented from being forced out by the weight of members positioned in upper part. That is, plate-like joining materials such as solder are disposed between power semiconductor devices 1, 2 and spacers 5, 6, between spacers 5, 6 and lower insulating substrate 9 and between devices and upper insulating substrate 18 and are heated to be melted simultaneously or separately to be used for joining. In this joining process, as shown in Fig. 5, resilient members such as springs 37, 38 are inserted or disposed between upper and lower insulating substrates 9, 18, so that the whole weight of upper insulating substrate 18 does not directly bear on joining materials to thereby prevent joining materials from being forced out of the devices. Even in this case, the springs 37, 38 may have natural length, for example, longer than the distance between insulating substrates 9, 18 to thereby reduce the weight of upper members bearing on joining materials.

Further, in the joining process of constituent elements of the power semiconductor module, assembly jigs 50 to 56 made of carbon as shown in Fig. 6 may be used to fix the springs 37, 38 by jigs 52 to 55. After joining is completed, springs 37, 38 may be removed or when springs 37, 38 are made of electrically insulating material, springs 37, 38 may be left after joining. Springs 37, 38 may be metallic coil springs or plate springs. Alternatively, resin material having resilience may be used instead of metal. However, even when it is used, it is necessary that the material can withstand high temperature occurring in the joining process.

After joining of constituent elements of the power semiconductor module is completed, all or parts of the surfaces and the sides of elements are thinly coated by flexible resin such as, for example, polyimide resin and polyamide-imide resin and are sealed by sealing resin 25 such as epoxy resin after the flexible resin is hardened. In the foregoing description, expression such as upper and lower sides is used for convenience, although the power semiconductor module may be disposed sideways or in any other direction and, for example, when it is disposed sideways, the upper and lower sides in the foregoing description may be exchanged by right and left sides, respectively.

According to the fabrication method of the power semiconductor module according to the embodiment, upper and lower heat spreaders for cooling both sides of the power semiconductor devices are disposed in the state that upper heat spreader is supported by resilient member such as spring, so that joining material such as solder is prevented from being forced out of insulating substrate so as not to cause short-circuiting. Moreover, insulating substrates are disposed over and under the power semiconductor device in the state that upper insulating substrate is supported by resilient member such as spring, so that joining material such as solder is prevented from being forced out from periphery of device so as not to cause short-circuiting. Accordingly, the power semiconductor module can be fabricated by the fabrication method to thereby provide the power semiconductor module having high reliability.

A power semiconductor module and its fabrication method according to another embodiment of the present invention are now described with reference to the drawings.

Fig. 7 is a sectional view illustrating a power semiconductor module and assembly jigs according to another embodiment (second embodiment) of the present invention. In the embodiment, when lower insulating substrate 9 and lower heat spreader 13 are joined to each other with joining material 12 and when upper insulating substrate 18 and upper heat spreader 23 are joined to each other with joining material 22, upper heat spreader 23 is hung from above by springs 48, 49. Springs 48 and 49 are supported by jigs 72 and 73, respectively. Springs 48, 49 may be metallic coil springs or plate springs. Alternatively, resin material having resilience may be used instead of metal. Upper heat spreader 23 is supported in this manner, so that the whole weight of heat spreader 23 does not directly bear on joining materials 12, 22 and accordingly joining materials such as solder can be prevented from being forced out of insulating substrate so as not to cause short-circuiting.

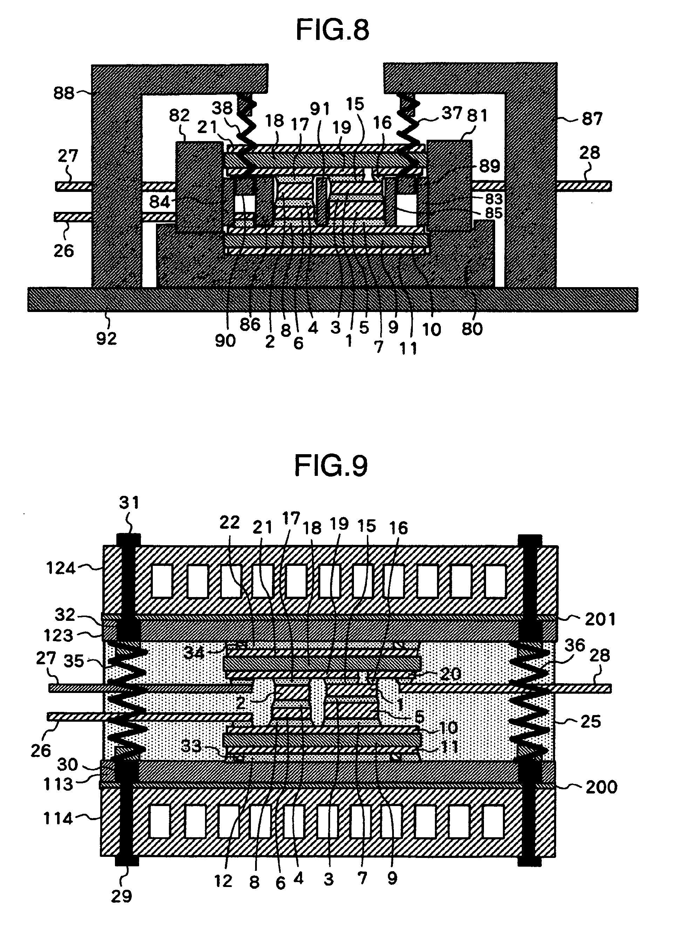

Fig. 8 is a sectional view illustrating a power semiconductor module and assembly jigs according to still another embodiment (third embodiment) of the present invention. In the embodiment, when power semiconductor devices 1, 2 and upper and lower insulating substrates 18, 9 are joined with joining material 7, 8, 15, 16 and 17, jigs 81 to 92 are used to hang the upper insulating substrate 18 by springs 37, 38. Jigs 89, 90 are attached to lower sides of springs, so that upper insulating substrate 18 is supported from bottom thereof by means of jigs 89, 90. Upper sides of springs 37, 38 are supported by jigs 87, 88. Jigs 87, 88 are fixed to jig 92. Thus, since the whole weight of upper insulating substrate and the like does not directly bear on joining materials, joining materials can be prevented from being forced out so as not to cause short-circuiting.

Fig. 9 is a sectional view illustrating a power semiconductor module according to a still further embodiment (fourth embodiment) of the present invention. In the embodiment, lower heat spreader 113 and lower heat sink 114 formed of aluminum die-casting are separate members and are brought into close contact with each other through grease 200. Upper heat spreader 123 and upper heat sink 124 are also separate members and are brought into close contact with each other through grease 201 similarly to the lower elements. Configuration of other parts is the same as the first embodiment. Even in the power semiconductor module fabricated thus, similarly to the first embodiment, lower and upper insulating substrates 9, 18 are joined to lower and upper heat spreaders 113, 123 with joining materials 12, 22, respectively, in the state that springs 35, 36 are inserted between upper and lower heat spreaders 113, 123, so that the whole weight of heat spreader and the like does not directly bear on solders 12, 22 and accordingly joining materials such as solder can be prevented from being forced out of insulating substrates so as not to cause short-circuiting.

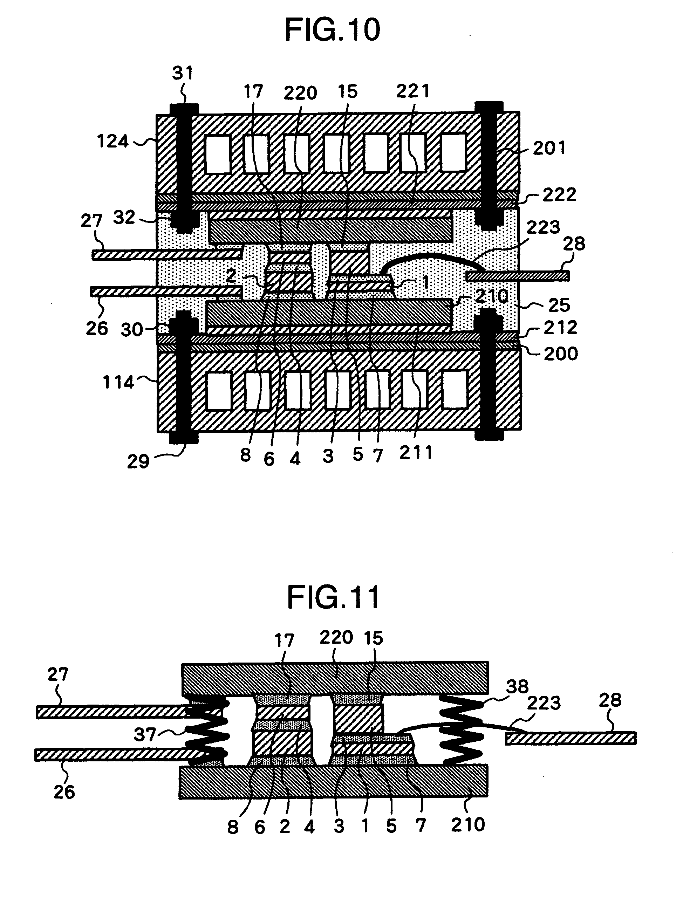

Fig. 10 is a sectional diagram illustrating a power semiconductor module according to still another embodiment (fifth embodiment) of the present invention. In the embodiment, lower sides of power semiconductor devices 1, 2 are connected to an electrode 210 having the function of heat spreader with solders 7, 8. Furthermore, upper sides of power semiconductor devices 1, 2 are connected to spacers 5, 6 with solders 3, 4 and the spacers 5, 6 are connected to electrode 220 having the function of heat spreader with solders 15, 17.

The lower electrode 210 and the upper electrode 220 are connected to leads 26 and 27 by soldering or ultrasonic joining, respectively, to be led outside. Gate electrode is connected to lead 28 through wire 223. Insulating resin 211 is disposed under lower electrode 210. Further, insulating resin 221 is disposed on upper electrode 220. Copper sheet 212 is disposed under lower insulating resin 211 and copper sheet 222 is also disposed on upper insulating resin 221. Insulating material such as aluminum nitride (A1N), alumina (Al₂O₃), silicon nitride (Si₃N₄) and boron nitride (BN) may be used instead of insulating resins as insulating resins 211, 221.

Grease 200 is applied between lower copper sheet 212 and heat sink 114 formed of aluminum die-casting and bolts 29 are driven against female threads 30 to thereby bring copper sheet 212 into close contact with heat sink 114. Grease 201 is applied between upper copper sheet 222 and heat sink 124 formed of aluminum die-casting and bolts 31 are driven against female threads 32 to thereby bring copper sheet 221 into close contact with heat sink 114. As shown in Fig. 11, power semiconductor devices 1, 2, spacers 5, 6 and electrodes 210, 220 are joined with solder in the state that springs 37, 38 are inserted between lower and upper electrodes 210 and 220.

As described above, according to the fabrication method of power semiconductor module according to representative embodiments of the present invention, constituent elements of the power semiconductor module are joined in the state that springs are inserted between heat spreaders or between insulating substrates, so that the whole weight of upper electrode 220 can be prevented from bearing on joining materials 3, 4, 7, 8 such as solder. Accordingly, It can be prevented that solder is forced out and short-circuiting occurs between electrodes. Therefore, according to the fabrication method of the power semiconductor module according to the embodiment of the present invention, high-reliable power semiconductor module can be fabricated.

The present invention is not limited to the above embodiments. For example, joining material for joining insulating substrates 9, 18 and heat spreaders 113, 123, joining material for joining power semiconductor devices 1, 2 (or spacers 5, 6) and upper lower insulating substrate 9, 18 and joining material for joining power semiconductor devices 1, 2 and electrodes 210, 220 may be all different or all identical or any of them may be identical.

It should be further understood by those skilled in the art that although the foregoing description has been made on embodiments of the invention, the invention is not limited thereto and various changes and modifications may be made without departing from the spirit of the invention and the scope of appended claims.

## Claims

1. A fabrication method of a power semiconductor module including first and second insulating substrates, a power semiconductor device joined directly or through another element to opposite sides of the first and second insulating substrates and first and second heat spreaders joined with joining material having fluidity upon joining so as to put the first and second insulating substrates between the first and second heat spreaders, comprising:
joining process of joining the first and second insulating substrates to the first and second heat spreaders, respectively, in the state that weight bearing on the joining material is reduced by means of a resilient member.

2. A fabrication method of a power semiconductor module according to Claim 1, wherein
in the joining process, the first and second insulating substrates are joined to the first and second heat spreaders, respectively, in the state that the resilient member is inserted between the first and second heat spreaders.

3. A fabrication method of a power semiconductor module according to Claim 2, wherein
the resilient member comprises spring having natural length longer than distance between the first and second heat spreaders.

4. A fabrication method of a power semiconductor module according to Claim 1, wherein
in the joining process, the first and second insulating substrates are joined to the first and second heat spreaders, respectively, in the state that an upper heat spreader of the first and second heat spreaders is hung by the resilient member supported by an upper part of the power semiconductor module.

5. A fabrication method of a power semiconductor module according to Claim 1, further comprising:
joining the power semiconductor device to the first and second insulating substrates with joining material having fluidity upon joining in the state that the resilient member is inserted between the first and second insulating substrates.

6. A fabrication method of a power semiconductor module according to Claim 1, further comprising:
joining the power semiconductor device to the first and second insulating substrates with joining material having fluidity upon joining in the state that an upper insulating substrate of the first and second insulating substrate is hang by the resilient member supported by an upper part of the power semiconductor module.

7. A fabrication method of a power semiconductor module according to Claim 5, wherein
the joining material used to join the power semiconductor device to the first and second insulating substrates has melting temperature higher than melting temperature of the joining material used to join the first and second insulating substrates to the first and second heat spreaders, respectively.

8. A fabrication method of a power semiconductor module according to Claim 1, wherein
the power semiconductor module further comprises first and second electrode plates joined directly or through another element to both sides of the power semiconductor device opposite to the first and second insulating substrates with joining material having fluidity upon joining,
the fabrication method further comprising:
joining the power semiconductor device to the first and first electrode plates with third joining material in the state that the resilient member is inserted between the first and second electrode plates.

9. A fabrication method of a power semiconductor module according to Claim 8, wherein
the joining material used to join the power semiconductor device to the first and first electrode plates has melting temperature higher than melting temperature of the joining material used to join the first and second insulating substrates to the first and second heat spreaders, respectively.

10. A fabrication method of a power semiconductor module according to Claim 1, wherein
the joining material comprises solder.

11. A fabrication method of a power semiconductor module according to Claim 1, wherein
the first and second insulating substrates have both sides to which metal sheet is joined.

12. A fabrication apparatus of a power semiconductor module including first and second insulating substrates, a power semiconductor device joined directly or through another element to opposite sides of the first and second insulating substrates and first and second heat spreaders joined with joining material having fluidity upon joining so as to put the first and second insulating substrates between the first and second heat spreaders, comprising:
means to reduce weight bearing on the joining material by means of a resilient member when the first and second insulating substrates are joined to the first and second heat spreaders, respectively.

13. A power semiconductor module comprising:
first and second insulating substrates;
a power semiconductor device joined directly or through another element to opposite sides of the first and second insulating substrates;
first and second heat spreaders joined with joining material having fluidity upon joining so as to put the first and second insulating substrates between the first and second heat spreader; and
a resilient member disposed between the first and second heat spreaders to reduce weight bearing on the joining material.

14. A method of joining first and second members constituting a power semiconductor module with joining material having fluidity upon joining, comprising:
disposing the first member over the second member; and
joining the first and second members with the joining material in the state that weight of the first member bearing on the second member is reduced.

15. A joining method according to Claim 14, comprising:
joining the first and second members with the joining material in the state that the first member is supported by resilient member.
